# EUROPÄISCHE PATENTSCHRIFT

(11) **EP 3 375 264 B1**
(45) Veröffentlichungstag und Bekanntmachung des Hinweises auf die Patenterteilung: **05.08.2020**
(21) Anmeldenummer: 16791561.0
(22) Anmeldetag: 02.11.2016
(51) Int. Cl.: H05K 3/34, B23K 1/012

(54) **VERFAHREN ZUM STABILISIEREN DES WIDERSTANDS ZWISCHEN LEITERBAHNEN**
PROCESS TO STABILIZE THE RESISTANCE BETWEEN CONDUCTIVE TRACKS
PROCÉDÉ POUR STABILISER LA RÉSISTANCE ENTRE PISTES CONDUCTRICES

(30) Priorität: 11.11.2015 DE 102015119487; 04.04.2016 DE 102016106106
(43) Veröffentlichungstag der Anmeldung: 19.09.2018
(73) Patentinhaber: Endress+Hauser SE+Co. KG, 79689 Maulburg (DE)
(72) Erfinder: BIRGEL, Dietmar, 79650 Schopfheim (DE); BANNWARTH, Alexander, 79739 Schwörstadt (DE); BERLINGER, Andrea, 76532 Baden-Baden (DE)
(74) Vertreter: Andres, Angelika Maria
(86) Internationale Anmeldenummer: PCT/EP2016/076397
(87) Internationale Veröffentlichungsnummer: WO 2017/080882

(56) Entgegenhaltungen:
- EP-A1- 0 544 934
- DE-A1- 19 602 312
- US-B1- 6 334 782

## Beschreibung

Die Erfindung bezieht sich auf ein Verfahren zum Stabilisieren des elektrischen Widerstands zwischen Leiterbahnen einer Leiterkarte, wobei die Leiterkarte Lötstopplack auf zu isolierenden Flächen zwischen den Leiterbahnen aufweist.

Leiterkarten bestehen aus elektrisch isolierendem Material mit daran haftenden Leiterbahnen, die zumeist aus einer dünnen Schicht Kupfer geätzt werden. Bauelemente werden auf Lötflächen, sogenannte Pads gelötet. So werden sie gleichzeitig mechanisch gehalten und elektrisch verbunden.

Der elektrische Widerstand zwischen zwei Leiterbahnen einer Leiterkarte wird durch das Material zwischen den Leiterbahnen bestimmt. Dieser Widerstand ist abhängig von Temperatur- und Feuchtigkeitsschwankungen.

In der europäischen Patentanmeldung EP 0 544 934 A1 ist offenbart, den Widerstand zwischen Elektroden auf der isolierenden Oberfläche eines Gegenstands gegenüber Feuchtigkeitsschwankungen zu stabilisieren, indem dieser beschichtet und anschließend einem Hochtemperaturprozess in einem Vakuum unterzogen wird.

Der Erfindung liegt die Aufgabe zugrunde, ein Verfahren zum Stabilisieren des elektrischen Widerstands zwischen Leiterbahnen einer Leiterkarte anzugeben.

Die Aufgabe wird durch den Gegenstand der Erfindung gelöst Gegenstand der Erfindung ist ein Verfahren zum Stabilisieren des elektrischen Widerstands zwischen Leiterbahnen einer Leiterkarte, wobei die Leiterkarte Lötstopplack auf zu isolierenden Flächen zwischen den Leiterbahnen aufweist, umfassend die Schritte, Behandeln der Leiterkarte in einer Dampfphasenlötanlage mittels eines Wärmeübertragungsmediums.

Das Behandeln der Leiterkarte in einer Dampfphasenlötanlage führt dazu, dass der Widerstand zwischen den Leiterbahnen weniger stark von Temperatur- und Feuchtigkeitsschwankungen wird. Anschließend können Bauelemente auf der Leiterkarte gelötet werden.

Gemäß einer vorteilhaften Ausgestaltung wird das Behandeln der Leiterkarte in der Dampfphasenlötanlage mehrmals, bevorzugt ein zweites Mal, wiederholt.

Gemäß einer günstigen Weiterbildung geschieht das Behandeln der Leiterkarte in einer Dampfphasenlötanlage bei Temperaturen zwischen 200 °C und 260 °C.

Gemäß einer günstigen Variante geschieht das Behandeln der Leiterkarte in einer Dampfphasenlötanlage bei Drücken zwischen 10 mbar und 100 mbar.

Gemäß einer günstigen Ausführungsform dauert das Behandeln der Leiterkarte in einer Dampfphasenlötanlage zwischen 4 Minuten und 12 Minuten.

Gemäß einer günstigen Ausgestaltung umfasst das Wärmeübertragungsmediums Perfluorpolyether.

Die Erfindung wird anhand der nachfolgenden Zeichnungen näher erläutert. Es zeigt:
Fig. 1: eine Draufsicht auf eine Leiterkarte mit zwei Leiterbahnen,
Fig. 2: eine Grafik eines zeitlichen Temperaturverlaufs und eines zeitlichen Druckverlaufs in der Dampfphasenlötanlage,
Fig. 3a: zeigt eine Grafik mit drei verschiedenen Widerstandsverläufen für eine erste Leiterkarte, und
Fig. 3b: zeigt eine Grafik mit drei verschiedenen Widerstandsverläufen für eine zweite Leiterkarte.

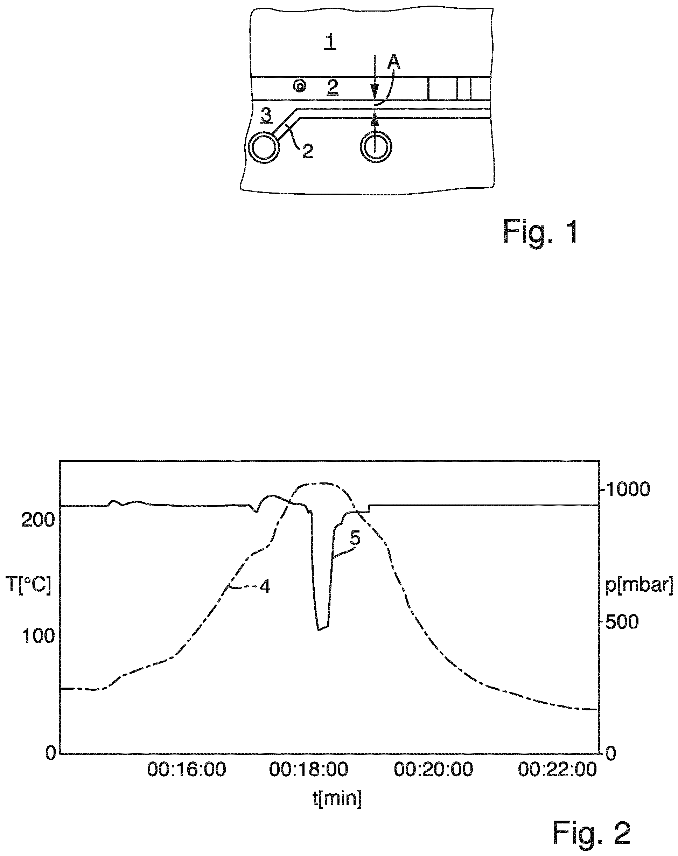

Fig. 1 zeigt eine Draufsicht auf eine Leiterkarte 1 mit zwei Leiterbahnen 2. Die Pfeile markieren den kürzesten Abstand A zwischen den zwei Leiterbahnen 2.

Der elektrische Widerstand zwischen den zwei Leiterbahnen 2 hängt von dem Abstand A ab, aber auch von der Umgebungstemperatur und der Umgebungsfeuchtigkeit.

Das Verfahren dient dazu, den Widerstand entlang des Abstands A unabhängiger von Temperaturänderungen und Feuchtigkeitsänderungen zu machen.

Das Verfahren zum Stabilisieren des elektrischen Widerstands zwischen den zwei Leiterbahnen 2 der Leiterkarte 1 umfasst folgende Schritte:
Zuerst wird Lötstopplack auf die zu isolierenden Flächen 3 der Leiterkarte 1 aufgetragen. Anschließend wird Flussmittel im Heißluftverzinnungsprozess auf die zu lötenden Flächen (nicht dargestellt) der Leiterkarte 1 aufgetragen. Zum Schluss wird die Leiterkarte 1 in einer Dampfphasenlötanlage mittels Perfluorpolyether behandelt, wobei das Behandeln der Leiterkarte 1 in der Dampfphasenlötanlage ein zweites Mal wiederholt wird.

Das Behandeln der Leiterkarte 1 in der Dampfphasenlötanlage geschieht bei einer Temperatur zwischen 200 °C und 260 °C und einem Druck zwischen 10 mbar und 100 mbar und dauert zwischen 4 Minuten und 12 Minuten.

Fig. 2 zeigt eine Grafik eines zeitlichen Temperaturverlaufs 4 und eines zeitlichen Druckverlaufs 5, die während der Behandlung der Leiterkarte 1 in der Dampfphasenlötanlage herrschen.

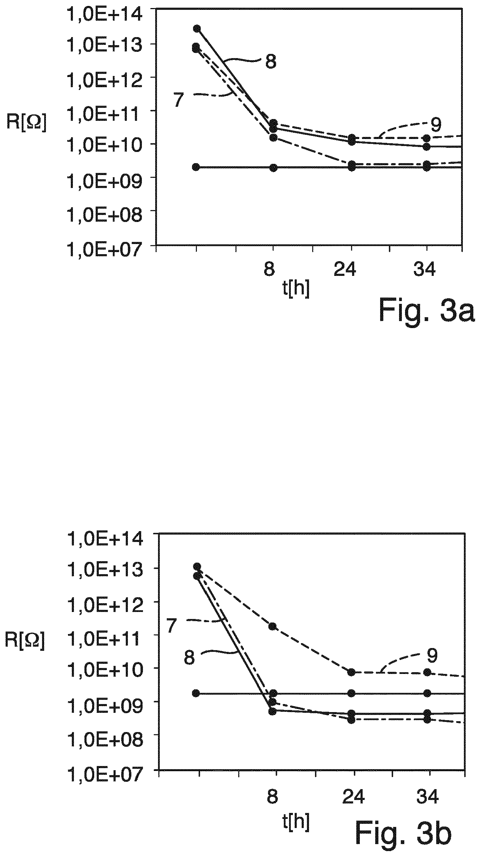

Fig. 3a zeigt eine Grafik mit drei verschiedenen zeitlichen Widerstandsverläufen 7, 8, 9 des Abstands A während die Leiterkarte besonderen Umgebungsbedingungen ausgesetzt ist.

Der erste Widerstandsverlauf 7 zeigt den zeitlichen Verlauf eines Widerstandswertes des Abstands A einer unbehandelten Leiterkarte. Im Originalzustand beträgt der Widerstand entlang des Abstands A ca. 10¹⁴ Ω.

Zum Zeitpunkt Null wird die Leiterkarte einer bestimmten Umgebung mit 40 °C Umgebungstemperatur und einer Luftfeuchtigkeit von 93 % ausgesetzt. Diese Umgebungsbedingungen beziehen sich auf einen Normtest, mit dem Elektroniken bis an ihre Grenzen beansprucht werden. Bereits nach 24 Stunden ist der Widerstandswert entlang des Abstands A auf ca. 10⁹ Ω abgefallen und kommt damit einem zulässigen Wert von ca. 10⁹ Ω nahe.

Der zweite Widerstandsverlauf 8 zeigt den Verlauf des Widerstandswertes entlang des Abstands A einer mit dem Verfahren zum Stabilisieren des elektrischen Widerstands von Lötstopplacken behandelten Leiterkarte. Man kann deutlich sehen, dass der Widerstandswert nach 24 Stunden lediglich bis ca. 10¹⁰ Ω abfällt. Dies ist gegenüber einer unbehandelten Leiterkarte eine Verbesserung von einer Größenordnung.

Der dritte Widerstandsverlauf 9 zeigt den Verlauf des Widerstandswertes entlang des Abstands A einer Leiterkarte nach einem zweifachen Durchlaufen des Verfahrens zum Stabilisieren des elektrischen Widerstands zwischen Leiterbahnen. Man kann deutlich sehen, dass der Widerstandswert nach 24 Stunden eine weitere Verbesserung gegenüber dem Widerstandswert nach einem einmaligen Durchlaufen des Verfahrens darstellt, da der Widerstand hier noch weniger von den Umgebungsbedingungen beeinflusst wird.

Fig. 3b zeigt drei verschiedene Widerstandsverläufe 7, 8, 9 entsprechend Fig. 3a, jedoch bei einem anderen Typ von Leiterkarte.

### Bezugszeichenliste

- 1: Leiterkarte
- 2: Leiterbahn
- 3: zu isolierende Fläche
- 4: Temperaturverlauf
- 5: Druckverlauf
- 6: Widerstandsverlauf entlang des Abstands A
- 7: Erster Widerstandsverlauf
- 8: Zweiter Widerstandsverlauf
- 9: Dritter Widerstandsverlauf
- A: Abstand

## Patentansprüche

1. Verfahren zum Stabilisieren des elektrischen Widerstands zwischen Leiterbahnen (2) einer Leiterkarte (1), wobei die Leiterkarte (1) Lötstopplack auf zu isolierenden Flächen zwischen den Leiterbahnen (2) aufweist, umfassend die Schritte,
Behandeln der Leiterkarte (1) in einer Dampfphasenlötanlage mittels eines Wärmeübertragungsmediums.

2. Verfahren nach Anspruch 1, wobei das Behandeln der Leiterkarte (1) in der Dampfphasenlötanlage mehrmals, bevorzugt ein zweites Mal, wiederholt wird.

3. Verfahren nach Anspruch 1 oder 2, wobei das Behandeln der Leiterkarte (1) in der Dampfphasenlötanlage bei Temperaturen zwischen 200 °C und 260 °C geschieht.

4. Verfahren nach mindestens einem der vorhergehenden Ansprüche, wobei das Behandeln der Leiterkarte (1) in der Dampfphasenlötanlage bei Drücken zwischen 10 mbar und 100 mbar geschieht.

5. Verfahren nach mindestens einem der vorhergehenden Ansprüche, wobei das Behandeln der Leiterkarte (1) in einer Dampfphasenlötanlage zwischen 4 Minuten und 12 Minuten dauert.

6. Verfahren nach mindestens einem der vorhergehenden Ansprüche, wobei das Wärmeübertragungsmediums Perfluorpolyether umfasst.

## Claims

1. Procedure designed to stabilize the electrical resistance between conductive tracks (2) of a printed circuit board (1), wherein the printed circuit board (1) has a solder mask on surfaces to be isolated between the conductive tracks (2),
said procedure comprising the following steps:
treatment of the printed circuit board (1) in a vapor phase soldering system using a heat transfer medium.

2. Procedure as claimed in Claim 1, wherein the treatment of the printed circuit board (1) in the vapor phase soldering system is repeated several times, preferably twice.

3. Procedure as claimed in Claim 1 or 2, wherein the printed circuit board (1) is treated in the vapor phase soldering system at temperatures between 200 °C and 260 °C.

4. Procedure as claimed in at least one of the previous claims, wherein the printed circuit board (1) is treated in the vapor phase soldering system at pressures between 10 mbar and 100 mbar.

5. Procedure as claimed in at least one of the previous claims, wherein the treatment of the printed circuit board (1) in a vapor phase soldering system lasts between 4 and 12 minutes.

6. Procedure as claimed in at least one of the previous claims, wherein the heat transfer medium is a perfluoropolyether.

## Revendications

1. Procédé destiné à la stabilisation d'une résistance électrique entre les pistes conductrices (2) d'une carte de circuit imprimé (1), la carte de circuit imprimé (1) comportant un vernis épargne sur les surfaces à isoler entre les pistes conductrices (2),
lequel procédé comprend l'étape suivante :
Traitement de la carte de circuit imprimé (1) dans une installation de brasage en phase vapeur au moyen d'un fluide de transfert de chaleur.

2. Procédé selon la revendication 1, pour lequel le traitement de la carte de circuit imprimé (1) dans l'installation de brasage en phase vapeur est répété plusieurs fois, de préférence deux fois.

3. Procédé selon la revendication 1 ou 2, pour lequel le traitement de la carte de circuit imprimé (1) dans l'installation de brasage en phase vapeur s'effectue à des températures comprises entre 200 °C et 260 °C.

4. Procédé selon l'une des revendications précédentes, pour lequel le traitement de la carte de circuit imprimé (1) dans l'installation de brasage en phase vapeur s'effectue à des pressions comprises entre 10 mbar et 100 mbar.

5. Procédé selon l'une des revendications précédentes, pour lequel le traitement de la carte de circuit imprimé (1) dans l'installation de brasage en phase vapeur dure entre 4 et 12 minutes.

6. Procédé selon l'une des revendications précédentes, pour lequel le fluide de transfert de chaleur est un perfluoropolyéther.
